# EUROPEAN PATENT SPECIFICATION

(11) **EP 2 612 471 B1**
(45) Date of publication and mention of the grant of the patent: **13.06.2018**
(21) Application number: 11822071.4
(22) Date of filing: 23.08.2011
(51) Int. Cl.: H03M 7/30, H04L 12/811, H04L 12/801, H04L 12/825

(54) **METHOD AND APPARATUS FOR GENERATING CONTROL PACKET**
VERFAHREN UND VORRICHTUNG ZUR ERZEUGUNG VON STEUERPAKETEN
PROCÉDÉ ET APPAREIL PERMETTANT DE GÉNÉRER UN PAQUET DE COMMANDE

(30) Priority: 13.06.2011 KR 20110057002; 10.09.2010 US 381577 P; 02.09.2010 US 379482 P
(43) Date of publication of application: 10.07.2013
(73) Proprietor: Samsung Electronics Co., Ltd., Gyeonggi-do 443-742 (KR)
(72) Inventor: KIM, Ho-Dong, Seoul 138-160 (KR); JUN, Hae-Young, Seoul 131-765 (KR); KWON, Hyuk-Choon, Seoul 133-070 (KR); PARK, Dong-Seek, Suwon-si Gyeonggi-do 443-470 (KR); JUNG, Soo-Yeon, Seoul 134-030 (KR)
(74) Representative: Appleyard Lees IP LLP
(86) International application number: PCT/KR2011/006198
(87) International publication number: WO 2012/030096

(56) References cited:
- EP-A1- 2 164 200
- KR-A- 20080 104 249
- KR-B1- 100 526 179
- US-A1- 2005 188 099
- US-A1- 2005 226 518
- US-A1- 2008 117 930
- US-A1- 2011 109 792
- US-B1- 7 054 362

## Description

### Technical Field

Aspects of the exemplary embodiments relate to methods and apparatuses for generating control packets, and more particularly, to methods and apparatuses for generating control packets that indicate whether a device supports a data rate modification function.

### Background Art

According to related data transmission art, when transmitting compressed data to devices, a data rate is modified to transmit the compressed data. That is, when transmitting compressed data to devices, if a channel through which the compressed data is to be transmitted is inappropriate or a bandwidth of available channels has decreased, the compressed data is transmitted at a substantially low data rate. If a channel condition is appropriate or a bandwidth of available channels has increased, the compressed data is transmitted at a substantially high data rate. Published patent application US2008117930 (A1) discloses A transmission bit rate control mechanism for a packet-based communication system in which sender transmission bit rates can vary over time is provided. Other examples of the prior art can be found in US2011/109792 and US 2005/226518.

### Disclosure of Invention

### Solution to Problem

Exemplary embodiments described herein provide for methods and apparatuses for generating control packets.

### Advantageous Effects of Invention

Aspects of the exemplary embodiments relate to methods and apparatuses for generating control packets can indicate whether a device supports a data rate modification function.

### Brief Description of Drawings

The above and other aspects and features will become more apparent by describing in detail exemplary embodiments thereof with reference to the attached drawings in which:
FIG. 1 is a flowchart illustrating a method of generating control packets, according to an exemplary embodiment;
FIGS. 2A through 2F are views for illustrating pixel blocks according to various exemplary embodiments;
FIG. 3 is a flowchart illustrating a method of modifying a data rate of uncompressed data, according to an exemplary embodiment;
FIG. 4 is a view for illustrating an audio/video (AV) capability request packet according to an exemplary embodiment;
FIG. 5 is a view for illustrating an AV capability response packet according to an exemplary embodiment;
FIG. 6 is a view for illustrating a feature list field according to an exemplary embodiment;
FIG. 7 is a view for illustrating a feature list field according to another exemplary embodiment;
FIG. 8 is a block diagram for illustrating an apparatus of generating a control packet, according to an exemplary embodiment; and
FIG. 9 is a block diagram for illustrating an apparatus for modifying a data rate regarding uncompressed data, according to an exemplary embodiment.

### Best Mode for Carrying out the Invention

According to an exemplary embodiment, there is provided a method of generating a control packet according to claim 1 herein. The method may include generating data rate information indicating whether a device supports a data rate modifying function regarding uncompressed data; and generating a control packet including the data rate information.

The control packet may further include second data rate information indicating whether the device supports a data rate modifying function regarding compressed data.

The control packet may further include a first field including the data rate information and the second data rate information.

The control packet may further include a second field including the data rate information and a third field including the second data rate information.

The data rate modifying function regarding uncompressed data may include generating, when the uncompressed data is uncompressed video data, at least one pixel block constituting of at least one reference pixel and at least one adjacent pixel adjacent to the at least one reference pixel from among pixels of a video frame regarding the uncompressed video data, and modifying the number of the at least one adjacent pixel included in each of the pixel blocks.

According to another exemplary embodiment, there is provided an apparatus according to claim 5 herein, for generating a control packet, which is installed in a device. The apparatus may involve an information generating unit generating data rate information indicating whether the device supports a data rate modifying function regarding uncompressed data; and a packet generating unit generating a control packet including the data rate information. According to another exemplary embodiment, there is provided a device according to claim 10 herein.

According to another exemplary embodiment, there is provided a computer-readable recording medium according to claim 9 herein, having embodied thereon a program for executing the method of generating a control packet. The method may involve generating data rate information indicating whether a device supports a data rate modifying function regarding uncompressed data; and generating a control packet including the data rate information.

### Mode for the Invention

This application claims the benefit of Korean Patent Application No. 10-2011-0057002, filed on June 13, 2011, in the Korean Intellectual Property Office, U.S. Provisional Patent Application No. 61/379,482, filed on September 2, 2010, and U.S. Provisional Patent Application No. 61/381,577, filed on September 10, 2010, in the U.S. Patent and Trademark Office, the disclosures of which are incorporated herein in their entirety by reference.

Exemplary embodiments will now be described more fully with reference to the accompanying drawings.

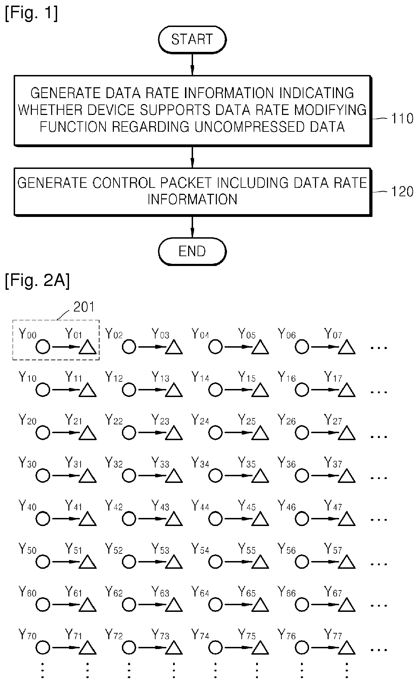

FIG. 1 is a flowchart illustrating a method of generating control packets, according to an exemplary embodiment.

In operation 110, data rate information is generated indicating whether a device supports a data rate modifying function for uncompressed data .

In operation 120, a control packet including the data rate information is generated.

Here, the control packet may further include second data rate information indicating whether a data rate modifying function regarding compressed data is supported.

A control packet including the data rate information may be used when notifying another device of information about whether a device supports a data rate modifying function regarding uncompressed data or not. If the other device receiving the control packet also supports a data rate modifying function regarding uncompressed data, the uncompressed data may be transmitted or received between the two devices based on the data rate modifying function regarding uncompressed data.

The data rate modifying function regarding uncompressed data according to an exemplary embodiment refers to, if the uncompressed data is uncompressed video data, a function of generating at least one pixel block which may include at least one reference pixel and at least one adjacent pixel to the at least one reference pixel from among pixels of an audio frame regarding the uncompressed audio data, and modifying the number of adjacent pixels included in each pixel block. Hereinafter, pixel blocks according to exemplary embodiments will be described with reference to FIGS. 2A through 2F.

FIGS. 2A through 2F are views for explaining pixel blocks according to exemplary embodiments.

In FIG. 2A, thirty-two pixel blocks are illustrated, each of which has a size of 1 pixel x 2 pixel.

In regards to the left uppermost pixel block 201, a circular pixel Y00 represents a reference pixel, and a triangular pixel Y01 represents an adjacent pixel. An arrow indicating a direction from Y00 to Y01 is illustrated, which indicates that a pixel value of the adjacent pixel Y01 is replaced with a difference value between pixels values of Y00 and Y01.

When the pixel value of Y01 is replaced with a difference value between pixel values of Y00 and Y01, generation of the pixel block 201 of the left uppermost section is completed, and the rest of the thirty-one pixel blocks are also generated in the substantially same manner as the pixel block 201 of the left uppermost section.

Hereinafter, a difference value between pixel values of two adjacent pixels will be referred to as a pixel difference value.

According to another embodiment, after pixel blocks are generated, packets may be generated in each of the pixel blocks such that a pixel value of a reference pixel and a pixel difference value of an adjacent pixel are allocated to different packets according to positions of pixels.

For example, in the exemplary embodiment of FIG. 2A, pixels values of the reference pixels Y00, Y02, Y04, Y06, ... , Y76 may be included in a first packet, and pixel difference values of the adjacent pixels Y01, Y03, Y05, Y07, ... , Y77 may be included in a second packet. The number of reference pixels within the first packet may be determined by the modified data rate as shown in the examples of FIG. 2A to FIG. 2F.

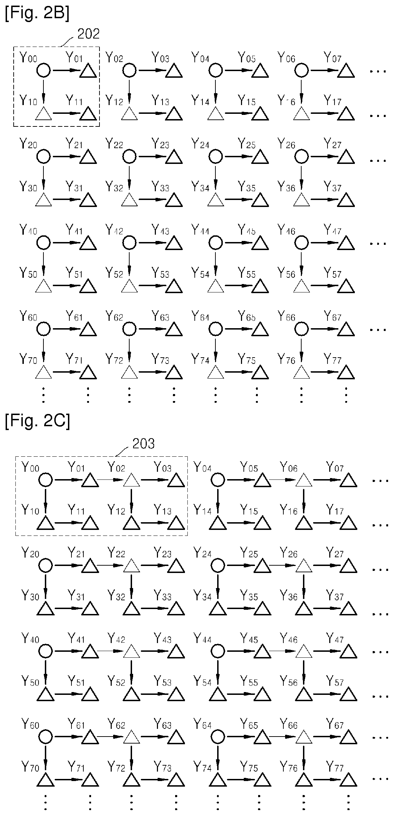

FIG. 2B illustrates sixteen pixel blocks, each of which has a size of 2 pixel x 2 pixel.

Regarding the pixel block 202 in a left uppermost section, a circular pixel Y00 represents a reference pixel, and triangular pixels Y01, Y10, and Y11 represent adjacent pixels. An arrow indicating a direction from Y10 to Y11 is illustrated, which indicates that the pixel value of the adjacent pixel Y11 is replaced with a difference value between pixels values of Y10 and Y11. That is, according to the embodiment FIG. 2B, a pixel difference value of the adjacent pixel Y11 may be generated not by referring to the reference pixel Y00 but to another adjacent pixel Y10. Accordingly, in order for a receiver to restore the pixel value of the adjacent pixel Y11, the pixel value of the adjacent pixel Y10 is to be restored first, and then the pixel value of the restored adjacent pixel Y10 is used to determine the pixel value of Y11.

In the pixel block 202 of the left uppermost section of FIG. 2B, the pixel value of the reference pixel Y00 may be included in a first packet, and a pixel value of the adjacent pixel Y01 may be included in a second packet, and the pixel value of the adjacent pixel Y10 may be included in a third packet, and the pixel value of the adjacent pixel Y11 may be included in a fourth packet. In the rest of the fifteen pixel blocks of FIG. 2B, pixel values and pixel difference values are allocated to the packets in the same manner as the pixel block 202 of the left uppermost section of FIG. 2B.

Here, the packets may be generated in the order of the first packet, the second packet, the third packet, and the fourth packet. That is, when a receiver side receives the packets, the most important packet is the first packet containing the reference pixels, and thus the first packet is to be generated first. Conversely, the adjacent pixels included in the fourth packet are generated last since they can be restored after the adjacent pixels included in the third packet are restored and thus are of lower importance. The number of packets containing pixel difference values that are generated and transmitted in addition to the second packet may be determined from the modified data rate and/or the number of reference pixels of the first packet. As noted in the foregoing exemplary embodiments and as noted above, additional packets containing difference values may be utilized in conjunction with the first packet, depending on the modified data rate. The packets with the pixel difference values may be transmitted sequentially to resolve the pixels in the pixel blocks.

According to another exemplary embodiment, unequal error protection (UEP) may also be applied to the packets according to the relative importance of the packets as disclosed below.

That is, in the above-described exemplary embodiment, the strongest error protection is applied to the first packet, and the weakest error protection may be applied to the fourth packet. For example, the number of bits allocated to packets for error restoration may be large in the order of the first packet, the second packet, the third packet, and the fourth packet.

FIG. 2C illustrates eight pixel blocks, each of which has a size of 2 pixel x 4 pixel.

In regards to the pixel block 203 in a left uppermost section, a circular pixel Y00 represents a reference pixel, and triangular pixels Y01, Y02, Y03, Y10, Y11, Y12, and Y13 represent adjacent pixels.

In the pixel block 203 in the left uppermost section of the exemplary embodiment of FIG. 2C, a pixel value of the reference pixel Y00 and pixel difference values of the adjacent pixels Y01, Y02, Y03, Y10, Y11, Y12, and Y13 are included in eight different packets according to the positions of the packets in the pixel block 203. In FIG. 2C, in the rest of the seven pixel blocks, pixel values and pixel difference values are allocated to the packets in the same manner as in the pixel block 203 of the left uppermost section of FIG. 2C.

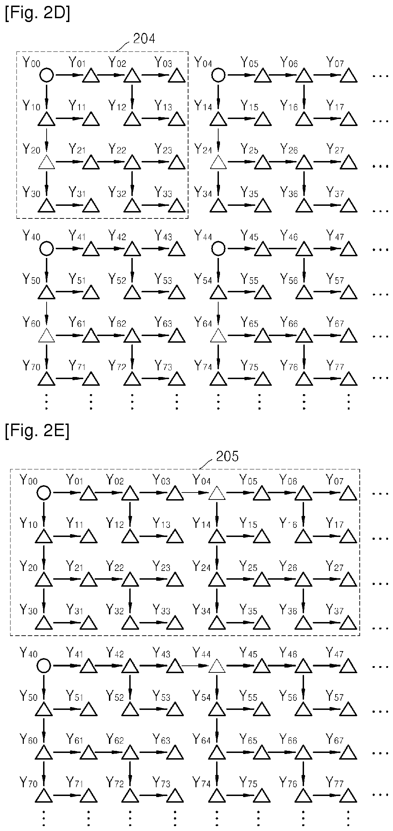

FIG. 2D illustrates four pixel blocks, each of which has a size of 4 pixel x 4 pixel.

In a pixel block 204 of the left uppermost section of FIG. 2D, a pixel value of a reference value Y00 and pixel difference values of fifteen adjacent pixels Y01 through Y33 are included in sixteen different packets according to positions of the pixels in the pixel block 204. Referring to FIG. 2D, in the rest of the three pixel blocks, pixel values and pixel difference values of the pixels are allocated to the packets in the same manner as in the pixel block 204 of the left uppermost section of FIG. 2D.

FIG. 2E illustrates two pixel blocks, each of which has a size of 4 pixel x 8 pixel.

In the pixel block 205 of an upper section of FIG. 2E, a pixel value of a reference value Y00 and pixel difference values of thirty-one adjacent pixels Y01 through Y37 are included in thirty-two different packets according to positions of the pixels in the pixel block 205. In the other pixel block of FIG. 2E, a pixel value of a reference pixel and pixel difference values of adjacent pixels are allocated to packets in the same manner as in the pixel block 205 of the upper section.

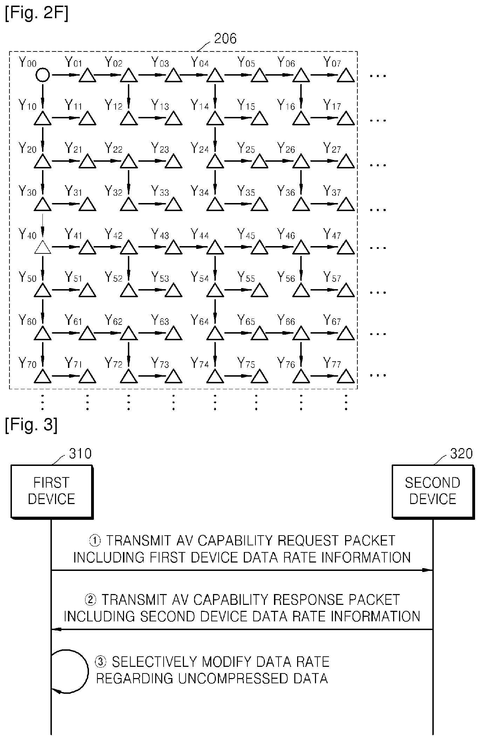

In FIG. 2F, one pixel block 206 is illustrated, which has a size of 8 pixel x 8 pixel.

In the pixel block 206 of FIG. 2F, a pixel value of a reference pixel Y00 and pixel difference values of sixty-three adjacent pixels Y01 through Y77 are included in sixty four different packets according to positions of the pixels in the pixel block 206.

While the position of the reference pixel is in the left uppermost section of each pixel block in FIGS. 2A through 2F, the exemplary embodiments described are not limited thereto. For example, the position of the reference pixel may be a right uppermost section of each pixel block.

Here, a data rate modifying function regarding uncompressed data according to an exemplary embodiment will be described with reference to the embodiments of FIGS. 2A through 2F: when a bandwidth of a channel through which the uncompressed data is to be transmitted is equal to or greater than a predetermined critical value, and a block mode of a pixel block is set as a 1 pixel x 2 pixel mode, as illustrated in FIG. 2A, to transmit uncompressed data using two packets, if the bandwidth of the channel is reduced to a value equal to or less than the predetermined critical value, the block mode of the pixel block is reset to a 8 pixel x 8 pixel mode as illustrated in FIG. 2F so as to transmit uncompressed data using sixty-four packets. As such, modifying a block mode of a pixel block according to the state of a channel is referred to as a data rate modifying function regarding uncompressed data.

A control packet including data rate information according to an exemplary embodiment may be an audio/video (AV) capability request packet, which is used by a device to request A/V capability of an opposite device, or an AV capability response packet corresponding to the AV capability request packet.

Hereinafter, a method of modifying a data rate regarding uncompressed data using an AV capability request packet and an AV capability response packet will be described with reference to FIG. 3.

FIG. 3 is a flowchart illustrating a method of modifying a data rate regarding uncompressed data, according to an exemplary embodiment.

In operation 1, a first device 310 transmits an AV capability request packet that includes first device data rate information indicating whether the first device 310 supports a data rate modifying function regarding uncompressed data and is used to request A/V capability of a second device 320, to the second device 320.

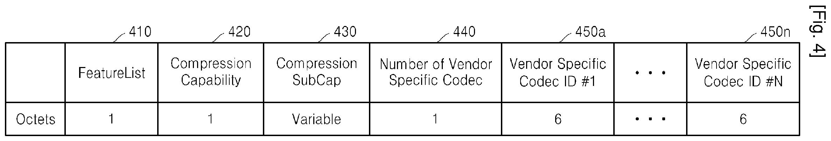

A structure of an AV capability request packet according to an exemplary embodiment will be described below with reference to FIG. 4.

In operation 2, the second device 320 transmits an AV capability response packet that includes data rate information indicating whether the second device 320 supports a data rate modifying function regarding uncompressed data and is a response to the AV capability request packet first device to the first device 310.

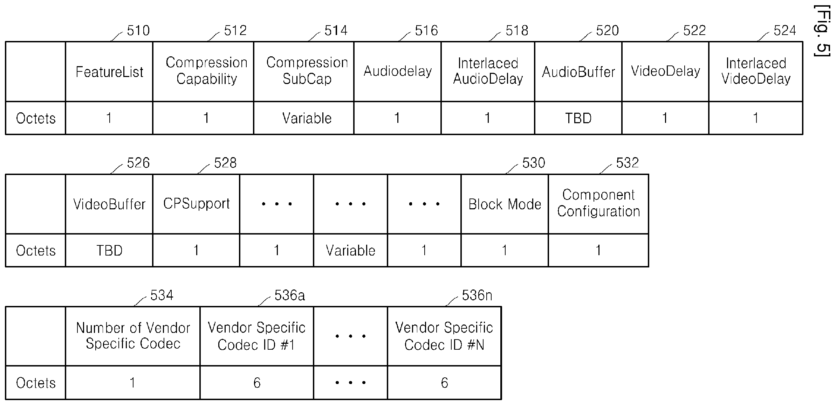

A structure of an AV capability response packet according to an exemplary embodiment will be described below with reference to FIG. 5.

In operation 3, the first device 310 selectively modifies a data rate regarding uncompressed data based on the second device data rate information.

That is, when it is indicated in the second device data rate information that the second device 320 supports the data rate modifying function regarding uncompressed data, the first device 310 modifies a data rate regarding uncompressed data. Otherwise, the first device 310 does not modify a data rate regarding uncompressed data.

According to another embodiment, an operation in which the first device 310 further transmits uncompressed data according to the modified data rate to the second device 320 may be further performed.

FIG. 4 is a view for explaining an AV capability request packet according to an exemplary embodiment.

Referring to FIG. 4, the AV capability request packet according to an embodiment of the present invention includes a feature list field 410, a compression capability field 420, a compression sub-capability field 430, a number of vendor specific codecs field 440, and a vendor specific codec identifier fields 450a through 450n.

The feature list field 410 represents A/V capability types that are supported by the first device 310.

The compression capability field 420 supports a compression type of a compression method supported by the first device 310.

The compression sub-capability field 430 represents specific sub-capabilities regarding each of the compression types supported by the first device 310.

The number of vendor specific codecs field 440 represents the number of vendor specific codecs supported by the first device 310.

The vendor specific codec identifier fields 450a through 450n each include an identifier to identify vendor specific codecs.

FIG. 5 is a view for explaining an AV capability response packet according to an exemplary embodiment.

Referring to FIG. 5, an AV capability response packet according to an exemplary embodiment includes a feature list field 510, a compression capability field 512, a compression sub-capability field 514, an audio delay field 516, an interlaced audio delay field 518, an audio buffer field 520, a video delay field 522, an interlaced video delay field 524, a video buffer field 526, a content protection (CP) support field 528, a block mode field 530, a component configuration field 532, a number of vendor specific codecs field 534, and vendor specific codec identifier fields 536a through 536n.

The feature list field 510 represents A/V capability types supported by the second device 320.

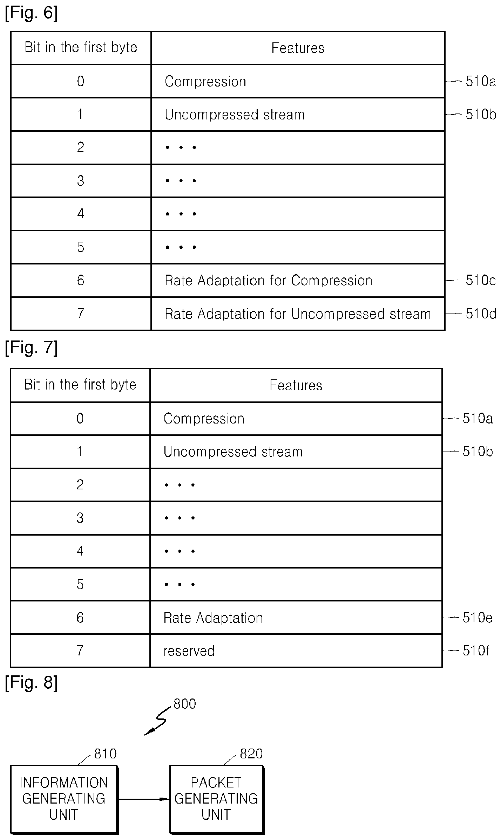

A structure of the feature list field 510 according to an embodiment of the present invention will be described below with reference to FIGS. 6 and 7.

The compression capability field 512 represents a compression type of a compression method supported by the second device 320.

The compression sub-capability field 514 represents a specific sub-capability of each compression method supported by the second device 320.

The audio delay field 516 represents a delay time when the second device 320 processes audio data. A unit of the delay time can be milliseconds (ms), or other units of time as appropriate.

The interlaced audio delay field 518 represents audio latency when video data in an interlaced video format is received. A unit of the delay time can be milliseconds (ms), or other units of time as appropriate.

The audio buffer field 520 denotes a size of buffer for audio processing in the second device 320. A unit of a buffer size can be Kbytes, or other buffer sizes may be utilized as appropriate.

The video delay field 522 denotes a delay time when the second device 320 processes audio data. A unit of delay time can be milliseconds (ms), or other units of time as appropriate.

The interlaced video delay field denotes a video latency when video data having an interlaced video format is received. A unit of delay time can be milliseconds (ms), or other units of time as appropriate.

The video buffer field 526 denotes a size of a buffer for video processing in the second device 320. A unit of a buffer size can be Kbytes, or other buffer sizes may be utilized as appropriate.

The CP support field 528 denotes content protection types supported by the second device 320.

When uncompressed data is uncompressed video data, the block mode field 530 denotes a block mode of a pixel block regarding pixels of a video frame of uncompressed video data supported by the second device 320. For example, a block mode may be a 1 pixel x 2 pixel mode, 2 pixel x 2 pixel mode, 2 pixel x 4 pixel mode, 4 pixel x 4 pixel mode, 4 pixel x 8 pixel mode, or 8 pixel x 8 pixel mode.

The component configuration field 532 denotes a color component configuration of uncompressed video data supported by the second device 320. For example, the component configuration field 532 may indicate which of RGB, YCbCr, and YCoCg formats uncompressed video data has.

The number of vendor specific codecs field 534 denotes the number of vendor specific codecs supported by the second device 320.

The vendor specific codec identifier fields 536a through 536n include identifiers for identifying vendor specific codecs.

FIG. 6 is a view for explaining the feature list field 510 according to an exemplary embodiment.

The feature list field 510 includes first through fourth sub-fields 510a through 510d.

The first sub-field 510a denotes whether the second device 320 supports a compressed data processing function.

The second sub-field 510b denotes whether the second device 320 supports an uncompressed stream data processing function.

The third sub-field 510c includes second data rate information indicating whether the second device 320 supports a data rate modifying function regarding compressed data.

For example, when the third sub-field 510c is marked as 0, it may denote that the second device 320 does not support a data rate modifying function regarding compressed data, and when marked as 1, it may denote that the second device 320 supports a data rate modifying function regarding compressed data.

The fourth sub-field 510d includes data rate information indicating whether the second device 320 supports a data rate modifying function regarding uncompressed data.

In Wireless Gigabit Alliance (WiGiG) A/V PAL format, WiGig spatial processing (WSP) is defined, wherein WSP is a function of supporting a data rate modifying function regarding uncompressed data.

For example, when the fourth sub-field 510d is marked as 0, it may denote that the second device 320 does not support a data rate modifying function (or WSP) regarding uncompressed data, and when it is marked as 1, it may denote that the second device 320 supports a data rate modifying function (or WSP) regarding uncompressed data.

FIG. 7 is a view for explaining a feature list field according to another exemplary embodiment.

A first sub-field 510a denotes whether the second device 320 supports a compressed data processing function.

A second sub-field 510b denotes whether the second device 320 supports an uncompressed stream data processing function.

A third sub-field 510e includes data rate information indicating whether the second device 320 supports a data rate modifying function regarding uncompressed data and second data rate information indicating whether the second device 320 supports a data rate modifying function regarding compressed data.

For example, when the third sub-field 510e is marked as 0, it may denote that the second device 320 does not support both a data rate modifying function regarding uncompressed data and a data rate modifying function regarding compressed data, and when the third sub-field 510e is marked as 1, it may denote that the second device 320 supports both a data rate modifying function regarding uncompressed data and a data rate modifying function regarding compressed data.

A fourth sub-field 510f is a reserved field left empty for use in the future.

While the structure of the feature list field 510 of an AV capability response packet has been described with reference to FIGS. 6 and 7, the feature list field 410 in the AV capability request field may have the same structure as that of the feature list field 510 of FIGS. 6 and 7 except that the feature list field 410 is used in the first device 310.

FIG. 8 is a block diagram for explaining an apparatus of generating a control packet, according to an exemplary embodiment.

Referring to FIG. 8, a control packet generating apparatus 800 includes an information generating unit 810 and a packet generating unit 820. Here, the packet generating apparatus 800 may be installed in a predetermined device.

The information generating unit 810 generates data rate information indicating whether a device in which the control packet generating apparatus 800 is installed supports a data rate modifying function regarding uncompressed data.

The packet generating unit 820 generates a control packet including the data rate information.

The control packet generating apparatus 800 may preferably further include a transmitting unit (not shown) transmitting control packets.

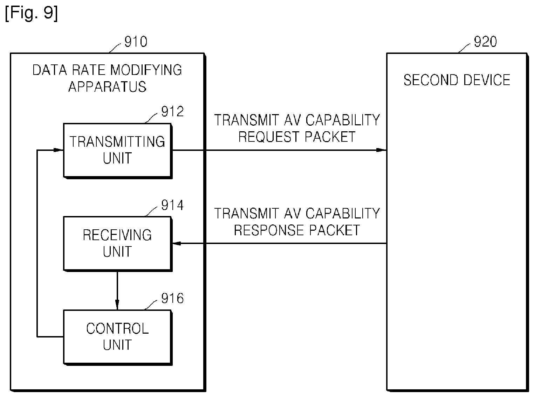

FIG. 9 is a block diagram for explaining an apparatus 910 for modifying a data rate regarding uncompressed data, according to an exemplary embodiment.

Referring to FIG. 9, the data rate modifying apparatus 910 includes a transmitting unit 912, a receiving unit 914, and a control unit 916. In FIG. 9, it is assumed that the data rate modifying apparatus 910 is installed in a first device (not shown), and a second device 920 is further illustrated for convenience of description.

The transmitting unit 912 transmits an AV capability request packet including first device data rate information indicating whether the first device supports a data rate modifying function regarding uncompressed data, to the second device 920.

The receiving unit 914 receives an AV capability response packet including second device data rate information indicating whether the second device 920 supports a data rate modifying function regarding uncompressed data, from the second device 920.

The control unit 916 selectively modifies a data rate regarding uncompressed data based on the first or second device data rate information.

Preferably, the control unit 916 may control such that after a data rate regarding uncompressed data is modified, the transmitting unit 912 transmits the uncompressed data at the modified data rate.

According to another embodiment, after the control unit 916 has compressed only some video frames according to a channel state, the transmitting unit 912 may be controlled to transmit the compressed video frames and other video frames that are not compressed.

For example, regarding a 3D video data, the control unit 916 may control such that only an L video frame is compressed from among an R video frame and an L video frame, and the transmitting unit 912 transmits the compressed L video frame and the uncompressed R video frame afterwards.

The embodiments can be written as computer programs and can be implemented in general-use digital computers that execute the programs using a computer-readable recording medium. Various units and modules of the exemplary embodiments may be executed by a processor.

Examples of the computer-readable recording medium include magnetic storage media (e.g., ROM, floppy disks, hard disks, etc.) and optical recording media (e.g., CD-ROMs, or DVDs).

While this invention has been particularly shown and described with reference to embodiments thereof, it will be understood by those skilled in the art that various changes in form and details may be made therein without departing from the scope of the invention as defined by the appended claims. The embodiments should be considered in descriptive sense only and not for purposes of limitation. Therefore, the scope of the invention is defined not by the detailed description of the invention but by the appended claims, and all differences within the scope will be construed as being included in the present invention.

## Claims

1. A method of generating a control packet, the method including:
generating first data rate information (110) indicating whether a device supports a data rate modifying function for uncompressed data; and
generating a control packet (120) including the first data rate information;
**characterised in that** the data rate modifying function for uncompressed data comprises generating, when the uncompressed data is uncompressed video data, at least one pixel block comprising at least one reference pixel and at least one adjacent pixel adjacent to the at least one reference pixel from pixels of a video frame of the uncompressed video data, and modifying a number of the at least one adjacent pixel included in each of the at least one pixel block.

2. The method of claim 1, wherein the control packet further comprises second data rate information indicating whether the device supports a second data rate modifying function for compressed data.

3. The method of claim 2, wherein the control packet further comprises a first field including the first data rate information and the second data rate information.

4. The method of claim 2, wherein the control packet further comprises a first field including the first data rate information and a second field including the second data rate information.

5. An apparatus for generating a control packet installed in a device, the apparatus including:
an information generating unit (810) arranged to generate first data rate information indicating whether the device supports a first data rate modifying function for uncompressed data; and
a packet generating unit (820) arranged to generate a control packet including the first data rate information;
**characterised in that** the data rate modifying function for uncompressed data comprises generating, when the uncompressed data is uncompressed video data, at least one pixel block comprising at least one reference pixel and at least one adjacent pixel adjacent to the at least one reference pixel from pixels of a video frame of the uncompressed video data, and modifying a number of the at least one adjacent pixel included in each of the at least one pixel block.

6. The apparatus of claim 5, wherein the control packet further comprises second data rate information indicating whether the device supports a data rate modifying function for compressed data.

7. The apparatus of claim 6, wherein the control packet comprises a first field including the first data rate information and the second data rate information.

8. The apparatus of claim 6, wherein the control packet comprises a first field including the first data rate information and a second field including the second data rate information.

9. A non-transitory computer-readable recording medium having embodied thereon a program for executing instructions including:
generating first data rate information (110) indicating whether a device supports a data rate modifying function for uncompressed data; and
generating a control packet (120) including the first data rate information;
**charactrerised in that** the data rate modifying function for uncompressed data comprises generating, when the uncompressed data is uncompressed video data, at least one pixel block comprising at least one reference pixel and at least one adjacent pixel adjacent to the at least one reference pixel from pixels of a video frame of the uncompressed video data, and modifying a number of the at least one adjacent pixel included in each of the at least one pixel block.

10. A device including:
a processor;
a transmitting unit (912) arranged to transmit a control packet including data rate information comprising an indication for whether the device supports a data rate modifying function for one of uncompressed data and compressed data; and
a control unit (916) arranged to modify a data rate based on received control packets;
**characterised in that** the transmitting unit is arranged to further transmit a first data packet comprising at least one reference pixel and a second data packet comprising pixel difference values for pixels adjacent to the at least one reference pixel; and
wherein a number of reference pixels to be transmitted in the first data packet as the at least one reference pixel is determined from the modified data rate.

11. The device of claim 10 wherein the transmitting unit is arranged to further transmit a number of additional data packets comprising pixel difference values, the number of additional packets to be transmitted determined from the modified data rate.

12. The device of claim 11, wherein the transmitting unit is arranged to transmit the first data packet first and transmits the second data packet and the additional data packets in sequence.

## Patentansprüche

1. Verfahren zum Erzeugen eines Steuerpakets, wobei das Verfahren Folgendes beinhaltet:
Erzeugen erster Datenrateninformationen (110), die angeben, ob eine Vorrichtung eine Datenratenmodifizierungsfunktion für unkomprimierte Daten unterstützt; und
Erzeugen eines Steuerpakets (120) einschließlich der ersten Datenrateninformationen;
**dadurch gekennzeichnet, dass** die Datenratenmodifizierungsfunktion für unkomprimierte Daten Erzeugen, wenn die unkomprimierten Daten unkomprimierte Videodaten sind, wenigstens eines Pixelblocks, der wenigstens ein Referenzpixel und wenigstens ein angrenzendes Pixel angrenzend an das wenigstens eine Referenzpixel umfasst, aus Pixeln eines Videorahmens der unkomprimierten Videodaten und Modifizieren einer Anzahl des wenigstens einen angrenzenden Pixels, das in jedem des wenigstens einen Pixelblocks enthalten ist, umfasst.

2. Verfahren nach Anspruch 1, wobei das Steuerpaket ferner zweite Datenrateninformationen umfasst, die angeben, ob die Vorrichtung eine zweite Datenratenmodifizierungsfunktion für komprimierte Daten unterstützt.

3. Verfahren nach Anspruch 2, wobei das Steuerpaket ferner ein erstes Feld einschließlich der ersten Datenrateninformationen und der zweiten Datenrateninformationen umfasst.

4. Verfahren nach Anspruch 2, wobei das Steuerpaket ferner ein erstes Feld einschließlich der ersten Datenrateninformationen und ein zweites Feld einschließlich der zweiten Datenrateninformationen umfasst.

5. Einrichtung zum Erzeugen eines Steuerpakets, die in einer Vorrichtung installiert ist, wobei die Einrichtung Folgendes beinhaltet:
eine Informationserzeugungseinheit (810), die zum Erzeugen erster Datenrateninformationen eingerichtet ist, die angeben, ob die Vorrichtung eine erste Datenratenmodifizierungsfunktion für unkomprimierte Daten unterstützt; und
eine Paketerzeugungseinheit (820), die zum Erzeugen eines Steuerpakets einschließlich der ersten Datenrateninformationen eingerichtet ist;
**dadurch gekennzeichnet, dass** die Datenratenmodifizierungsfunktion für unkomprimierte Daten Erzeugen, wenn die unkomprimierten Daten unkomprimierte Videodaten sind, wenigstens eines Pixelblocks, der wenigstens ein Referenzpixel und wenigstens ein angrenzendes Pixel angrenzend an das wenigstens eine Referenzpixel umfasst, aus Pixeln eines Videorahmens der unkomprimierten Videodaten und Modifizieren einer Anzahl des wenigstens einen angrenzenden Pixels, das in jedem des wenigstens einen Pixelblocks enthalten ist, umfasst.

6. Einrichtung nach Anspruch 5, wobei das Steuerpaket ferner zweite Datenrateninformationen umfasst, die angeben, ob die Vorrichtung eine Datenratenmodifizierungsfunktion für komprimierte Daten unterstützt.

7. Einrichtung nach Anspruch 6, wobei das Steuerpaket ein erstes Feld einschließlich der ersten Datenrateninformationen und der zweiten Datenrateninformationen umfasst.

8. Einrichtung nach Anspruch 6, wobei das Steuerpaket ein erstes Feld einschließlich der ersten Datenrateninformationen und ein zweites Feld einschließlich der zweiten Datenrateninformationen umfasst.

9. Nichtflüchtiges computerlesbares Aufzeichnungsmedium mit einem darauf umgesetzten Programm zum Ausführen von Anweisungen, die Folgendes beinhalten:
Erzeugen erster Datenrateninformationen (110), die angeben, ob eine Vorrichtung eine Datenratenmodifizierungsfunktion für unkomprimierte Daten unterstützt; und
Erzeugen eines Steuerpakets (120) einschließlich der ersten Datenrateninformationen;
**dadurch gekennzeichnet, dass** die Datenratenmodifizierungsfunktion für unkomprimierte Daten Erzeugen, wenn die unkomprimierten Daten unkomprimierte Videodaten sind, wenigstens eines Pixelblocks, der wenigstens ein Referenzpixel und wenigstens ein angrenzendes Pixel angrenzend an das wenigstens eine Referenzpixel umfasst, aus Pixeln eines Videorahmens der unkomprimierten Videodaten und Modifizieren einer Anzahl des wenigstens einen angrenzenden Pixels, das in jedem des wenigstens einen Pixelblocks enthalten ist, umfasst.

10. Vorrichtung, die Folgendes beinhaltet:
einen Prozessor;
eine Übertragungseinheit (912), die zum Übertragen eines Steuerpakets einschließlich Datenrateninformationen eingerichtet ist, die eine Angabe umfassen, ob die Vorrichtung eine Datenratenmodifizierungsfunktion für entweder unkomprimierte Daten oder komprimierte Daten unterstützt; und
eine Steuereinheit (916), die zum Modifizieren einer Datenrate basierend auf empfangenen Steuerpaketen eingerichtet ist;
**dadurch gekennzeichnet, dass** die Übertragungseinheit ferner zum Übertragen eines ersten Datenpakets, das wenigstens ein Referenzpixel umfasst, und eines zweiten Datenpakets, das Pixeldifferenzwerte für Pixel, die an das wenigstens eine Referenzpixel angrenzen, umfasst; und
wobei eine Anzahl an Referenzpixeln, die in dem ersten Datenpaket als das wenigstens eine Referenzpixel zu übertragen sind, aus der modifizierten Datenrate bestimmt wird.

11. Vorrichtung nach Anspruch 10, wobei die Übertragungseinheit ferner zum Übertragen einer Anzahl an zusätzlichen Datenpaketen eingerichtet ist, die Pixeldifferenzwerte umfassen, wobei die Anzahl an zusätzlichen zu übertragenden Paketen aus der modifizierten Datenrate bestimmt.

12. Vorrichtung nach Anspruch 11, wobei die Übertragungseinheit zum Übertragen des ersten Datenpakets als Erstes und zum Übertragen des zweiten Datenpakets und der zusätzlichen Datenpakete der Reihe nach eingerichtet ist.

## Revendications

1. Procédé de génération d'un paquet de commande, le procédé consistant :
à générer des premières informations de débit de données (110) indiquant si un dispositif prend en charge ou non une fonction de modification de débit de données pour des données décompressées ; et
à générer un paquet de commande (120) comportant les premières informations de débit de données ;
**caractérisé en ce que** la fonction de modification de débit de données pour des données décompressées consiste à générer, lorsque les données décompressées sont des données vidéo décompressées, au moins un bloc de pixels comprenant au moins un pixel de référence et au moins un pixel adjacent qui est adjacent au ou aux pixels de référence parmi des pixels d'une trame vidéo des données vidéo décompressées, et à modifier le pixel adjacent ou un certain nombre de pixels adjacents inclus dans le bloc de pixels ou dans chaque bloc de pixels.

2. Procédé selon la revendication 1, dans lequel le paquet de commande comprend en outre des secondes informations de débit de données indiquant si le dispositif prend en charge ou non une seconde fonction de modification de débit de données pour des données compressées.

3. Procédé selon la revendication 2, dans lequel le paquet de commande comprend en outre un premier champ comprenant les premières informations de débit de données et les secondes informations de débit de données.

4. Procédé selon la revendication 2, dans lequel le paquet de commande comprend en outre un premier champ comprenant les premières informations de débit de données et un second champ comprenant les secondes informations de débit de données.

5. Appareil pour générer un paquet de commande installé dans un dispositif, l'appareil comprenant :
une unité de génération d'informations (810) conçue pour générer des premières informations de débit de données indiquant si le dispositif prend en charge ou non une première fonction de modification de débit de données pour des données décompressées ; et
une unité de génération de paquet (820) conçue pour générer un paquet de commande comportant les premières informations de débit de données ;
**caractérisé en ce que** la fonction de modification de débit de données pour des données décompressées consiste à générer, lorsque les données décompressées sont des données vidéo décompressées, au moins un bloc de pixels comprenant au moins un pixel de référence et au moins un pixel adjacent qui est adjacent au ou aux pixels de référence parmi des pixels d'une trame vidéo des données vidéo décompressées, et à modifier le pixel adjacent ou un certain nombre de pixels adjacents inclus dans le bloc de pixels ou dans chaque bloc de pixels.

6. Appareil selon la revendication 5, dans lequel le paquet de commande comprend en outre des secondes informations de débit de données indiquant si le dispositif prend en charge ou non une fonction de modification de débit de données pour des données compressées.

7. Appareil selon la revendication 6, dans lequel le paquet de commande comprend un premier champ comprenant les premières informations de débit de données et les secondes informations de débit de données.

8. Appareil selon la revendication 6, dans lequel le paquet de commande comprend un premier champ comprenant les premières informations de débit de données et un second champ comprenant les secondes informations de débit de données.

9. Support d'enregistrement non transitoire lisible par ordinateur sur lequel est intégré un programme pour exécuter des instructions consistant :
à générer des premières informations de débit de données (110) indiquant si un dispositif prend en charge ou non une fonction de modification de débit de données pour des données décompressées ; et
à générer un paquet de commande (120) comportant les premières informations de débit de données ;
**caractérisé en ce que** la fonction de modification de débit de données pour des données décompressées consiste à générer, lorsque les données décompressées sont des données vidéo décompressées, au moins un bloc de pixels comprenant au moins un pixel de référence et au moins un pixel adjacent qui est adjacent au ou aux pixels de référence parmi des pixels d'une trame vidéo des données vidéo décompressées, et à modifier le pixel adjacent ou un certain nombre de pixels adjacents inclus dans le bloc de pixels ou dans chaque bloc de pixels.

10. Dispositif comprenant :
un processeur ;
une unité de transmission (912) conçue pour transmettre un paquet de commande comportant des informations de débit de données comprenant une indication pour savoir si le dispositif prend en charge ou non une fonction de modification de débit de données pour des données décompressées ou pour des données compressées ; et
une unité de commande (916) conçue pour modifier un débit de données en se basant sur des paquets de commande reçus ;
**caractérisé en ce que** l'unité de transmission est conçue pour transmettre en outre un premier paquet de données comprenant au moins un pixel de référence et un second paquet de données comprenant des valeurs de différence de pixel pour des pixels adjacents au ou aux pixels de référence ; et
dans lequel un certain nombre de pixels de référence à transmettre dans le premier paquet de données comme étant le ou les pixels de référence est déterminé à partir du débit de données modifié.

11. Dispositif selon la revendication 10, dans lequel l'unité de transmission est conçue pour transmettre en outre un certain nombre de paquets de données supplémentaires comprenant des valeurs de différence de pixel, le nombre de paquets supplémentaires à transmettre déterminé à partir du débit de données modifié.

12. Dispositif selon la revendication 11, dans lequel l'unité de transmission est conçue pour transmettre d'abord le premier paquet de données et transmet le second paquet de données et les paquets de données supplémentaires en séquence.
